# FASCICULE DE BREVET EUROPEEN

(11) **EP 1 135 335 B1**
(45) Date de publication et mention de la délivrance du brevet: **02.05.2003**
(21) Numéro de dépôt: 99972193.9
(22) Date de dépôt: 15.11.1999
(51) Int. Cl.: C01G 27/02, C03C 17/00, C03C 17/245, C03C 17/34, C23C 14/08, C23C 14/54

(54) **COUCHE MINCE D'OXYDE D'HAFNIUM ET PROCEDE DE DEPOT**
DÜNNFILM AUS HAFNIUMOXID UND VERFAHREN ZUM AUFBRINGEN
THIN HAFNIUM OXIDE FILM AND METHOD FOR DEPOSITING SAME

(30) Priorité: 16.11.1998 FR 9814350
(43) Date de publication de la demande: 26.09.2001
(73) Titulaire: COMMISSARIAT A L'ENERGIE ATOMIQUE, 75752 Paris Cédex 15 (FR)
(72) Inventeur: ANDRE, Bernard, F-38100 Grenoble (FR); DIJON, Jean, F-38800 Champagnier (FR); RAFIN, Brigitte, F-38000 Grenoble (FR)
(74) Mandataire: Poulin, Gérard
(86) Numéro de dépôt international: FR9902797
(87) Numéro de publication internationale: WO00029330

(56) Documents cités:
- EP-A- 0 486 475
- US-A- 5 670 248
- STOLZ ET AL: "influence of microstructure on laser damage threshold of ibs coatings" 27TH ANNUAL BOULDER DAMAGE SYMPOSIUM PROC. (LASER-INDUCED DAMAGE IN OPTICAL MATERIALS:1995,1995, pages 351-359, XP002111763 usa

## Description

L'invention se situe dans le domaine des couches minces d'oxyde d'hafnium ou d'empilements de couches minces comprenant au moins une couche d'oxyde d'hafnium. Elle concerne également un procédé de réalisation de couches minces d'oxyde d'hafnium. Ces couches minces sont des couches apparaissant dans des structures multicouches incorporant outre les couches d'oxyde d'hafnium, des couches d'autres compositions.

### Art antérieur.

Le dépôt de couches minces d'oxydes d'hafnium, comme d'ailleurs beaucoup d'autres dépôts, est effectué de façon connue par évaporation sous vide. Le principe de base est le suivant :

Dans une chambre à vide, un canon à électrons échauffe une cible constituée du matériau à déposer. Le matériau est alors vaporisé et se dépose sur un substrat que l'on a placé à proximité. On peut aussi dans le cas du dépôt d'un oxyde, effectuer la même opération en partant du produit à oxyder, par exemple un métal, la chambre à vide contenant de l'oxygène sous très basse pression. Ce dernier procédé est connu sous le nom "d'évaporation réactive sous oxygène".

Dans le cas de l'oxyde d'hafnium, les deux techniques sont utilisées mais pour des raisons qui vont être explicitées ultérieurement, elles sont toujours associées à des moyens énergétiques tels qu'un chauffage direct du substrat, un bombardement ionique de la couche en cours de croissance, ou encore une accélération des ions du matériau à déposer au moyen d'un champ électrique, de telle sorte qu'ils apportent de l'énergie au substrat.

Les procédés de dépôt sont décrits de façon plus détaillées, par exemple dans le manuel de J. D. RANCOURT "Optical thin film user handbook, SPIE Press, 1996" (C1).

La réalisation de couches d'oxyde d'hafnium ou hafnie (HfO₂) est utilisée principalement dans les revêtements multicouches de composants optiques soumis à de forts flux laser. La fonction des couches d'hafnie peut être d'assurer la protection de composants auxquels elles sont adjointes.

Le composant incorporant de telles couches d'hafnie peut assurer à lui seul la protection au flux laser et la fonction optique du composant. La composition multicouche peut également être déposée comme revêtement protecteur sur un composant optique préexistant pour atténuer le flux laser subi par ce composant optique. Les couches d'hafnie assurent des protections dans la gamme des longueurs d'onde allant de l'ultraviolet à l'infrarouge pour tout type de laser, impulsionnel ou continu.

Les composants multicouches incorporant les couches d'hafnie assurent des fonctions optiques par exemple de miroir, filtre spectral ou antireflet.

La réalisation de ces fonctions optiques particulières nécessite la réalisation de traitements de surface. Il s'agit, par un d'empilement adéquat de matériaux d'indices de réfraction différents, de créer un système interférentiel qui crée la fonction optique désirée.

On utilise pour cela deux ou plusieurs matériaux que l'on dépose alternativement. En général, deux matériaux, l'un à haut indice et l'autre à bas indice suffisent pour répondre à la majorité des applications.

De nombreux matériaux peuvent jouer ce rôle. Nous citons par exemple :
- l'oxyde de silicium ou silice (SiO₂)
- l'alumine (Al₂O₃)
- le dioxyde de titane (TiO₂)
- le fluorure d'yttrium (YF₃)

Dans le cas particulier des optiques soumises à de forts flux laser, on définit le seuil d'endommagement laser (SEL) des empilements comme la valeur de la fluence (ou énergie reçue par unité de surface) à partir de laquelle apparaît une modification permanente du traitement de surface. Des indications sur les modes de réalisation de couches ayant des seuils d'endommagement élevés pourront être trouvés dans un livre de M. R. KOZLOWSKI "Thin film for Optical Systems" édité par F. R. Flory en 1995, (C2). Le chapitre 17 de ce livre page 521 et suivantes donne les tendances actuelles dans le choix des matériaux constituant les couches, des méthodes de mesure des dommages et des méthodes de déposition. Dans ce chapitre, il est notamment indiqué au paragraphe 3-5 pages 536-537, que les techniques de déposition avec des moyens énergétiques, comme par exemple, avec un bombardement ionique sont devenues d'un usage très large en raison de meilleurs possibilités de contrôle de l'épaisseur et de la stabilité mécanique de la couche. Ces procédés conduisent à des couches ayant des défauts limités.

L'endommagement des composants optiques est le facteur limitant les fluences maximales de travail des lasers. Ceci motive les recherches dans l'amélioration des seuils d'endommagement laser des traitements de surface.

De nombreuses familles de matériaux ont été étudiées dans ce cadre, on peut citer à titre d'exemple, les matériaux fluorures, chalcogénures, et oxydes. Ces derniers sont les plus étudiés dans le cadre des traitements de surface présentant des seuils d'endommagement laser élevés.

Pour les applications à fort flux laser dans le proche infrarouge, le couple HfO₂/SiO₂, est en général retenu étant donné les seuils d'endommagement laser élevés des composants obtenus. Des exemples de résultats obtenus avec ce couple sont décrits dans diverses applications. Ces publications indiquent en général de quelle manière ont été déposées les couches. Des exemples de telles publications sont cités, ci-après, pour information et pour une meilleure compréhension de ce qui va suivre. Un article de Allan J. WARLDORF et Al. publié le 1.10.93 dans la revue "Applied Optics" Vol. 32 n° 28 pages 5583-5593 (C3) décrit des méthodes et des résultats obtenus en matière de seuil d'endommagement avec ce couple. Cet article explique (notamment page 5583 seconde colonne) que les procédés par évaporation avec chauffage du produit à évaporer par résistance chauffante ou par faisceau électronique permettent des réalisations rapides mais non satisfaisantes, en particulier du point de vue des seuils d'endommagement. Il indique que la porosité des films peut être diminuée par accroissement de la température du substrat, ou encore par accélération des ions à déposer.

Il est indiqué aussi que les résultats obtenus avec les méthodes par accélération ionique (ion plating) ont encouragé les fabricants de filtres à utiliser cette méthode qui a donc tendance à se généraliser (p. 5584 haut de la colonne 2).

D'autres articles, par exemple, de BRAUN et al. intitulé "Optical coating for high - power neodymium lasers" paru dans la revue SOV. J. Quantum Electron 18 (10) - 1988 - page 1286-1290 (C4) ou encore celui de L. L. Chase et al., " Investigation of optical damage mechanisms in hafnia and silica thin films using pairs of subnanosecond laser pulses with variable time delay, J. Applied Physics , 71(3)(1992), pp 1204-1208" (C5) donnent les résultats d'endommagement obtenus avec des couches d'oxydes réfractaires et notamment des oxydes d'hafnium.

Dans les deux articles cités ci-dessus (C4-C5), les revêtements ont été obtenus par évaporation par faisceau électronique. Dans le second de ces articles (C5) il est indiqué (page 1204, bas de la colonne 2) que les substrats ont été maintenus pendant la déposition à une température de 200°C.

Dans la grande majorité des travaux publiés, les revêtements sont élaborés par évaporation sous vide à partir d'un précurseur d'oxyde d'hafnium.

Parmi les citations déjà effectuées plus haut, on peut citer à ce sujet, les documents C2, C4, C5 et aussi l'article de R.J. Tench et al., " Characterization of defects geometries in multilayer optical coatings, J. Vac. Sci. Technol. A 12(5) (1994) pp 2808 " (C6).

Cette technique d'élaboration, directement à partir de l'oxyde, présente l'inconvénient de générer dans les revêtements de nombreux défauts dus à des projections issues de la charge d'oxyde durant l'évaporation.

Ces défauts enterrés dans l'empilement sont identifiés comme des précurseurs de l'endommagement des optiques sous flux laser. On pourra consulter à ce sujet l'article de R. Chow et al., " Reactive evaporation of low-defect density hafnia, Applied Optics. vol. 32 n° 28 (1993) pp 5567 " (C7).

Assez peu de publications relatives à la réalisation de composants à partir d'évaporation réactive d'hafnium métal sous oxygène sont disponibles dans la littérature ouverte.

Outre le document C7, déjà cité, on peut cependant citer, par exemple, l'article de J. F. Anzellotti et al., "Stress and environmental shift characteristics of HfO₂/SIO₂ multilayer coating. Proceedings of the 28th annual Boulder Damage Symposium, SPIE Vol. 2966 (1996)" (C8).

Dans le document C7, les résultats obtenus par les techniques d'évaporation d'hafnium métal et d'hafnie sont comparés.

Bien que présentant des résultats attrayants sur la réduction de la densité de défauts de type nodulaire, les auteurs ne mettent pas en évidence d'amélioration des seuils d'endommagement laser des revêtements réalisés par évaporation réactive de métal sous oxygène. On peut penser que la présence de nodules dans les revêtements ne constitue un facteur de l'endommagement laser qu'une fois les performances ultimes des matériaux atteintes.

Compte tenu de l'état de la technique, les inventeurs ont pensé que l'on pouvait obtenir de bons résultats en matière de résistance à l'endommagement laser, pour la production de couches assurant des fonctions optiques par exemple de type miroir, filtre spectral ou antireflet, à partir de l'évaporation réactive d'hafnium métal sous oxygène, mais à condition de maîtriser les conditions de croissance des couches notamment la formation d'agrégats et la cristallinité.

Il est connu, par exemple de l'article de B. A. Movchan et al. Fiz. Met. Mettaloved, 28 (1969) pp 653 (C9) que la structure et les propriétés des condensats de métaux ou oxydes dépendent fortement de la température du substrat sur lequel la condensation est effectuée.

Les inventeurs ont donc cherché à mieux comprendre la croissance cristalline et la formation des agrégats métalliques et partant les façons de les éviter.

Les procédés non énergétiques à base d'évaporation produisent des revêtements qui présentent une forte porosité.

En effet, l'énergie des espèces évaporées est relativement faible : celle-ci est fonction de la température d'évaporation du matériau mais typiquement de l'ordre de quelques dixièmes d'électrons-volts (eV). Ceci conduit à une très faible mobilité des espèces qui se condensent à la surface du substrat. Dans l'intervalle de temps qui correspond au dépôt de deux monocouches atomiques successives, les déplacements des atomes ne sont pas suffisants pour induire la compaction des couches et l'on "enterre" ces lacunes. On induit de cette façon une microstructure des couches poreuses, caractéristique des dépôts obtenus par évaporation. Ceci a pour conséquence, de produire des revêtements plus difficiles à maîtriser pour les raisons suivantes :
- apparition de contraintes mécaniques de tension dans les couches qui sont défavorables à la stabilité des empilements si l'on ne met pas en oeuvre des mécanismes spécifiques de compensation ;
- évolution dans le temps de la réponse optique du composant (le remplissage progressif des porosités par de l'eau induisant des glissements d'indice de réfraction moyen) ;
- dérive de procédé, la part du rayonnement thermique des charges d'évaporation n'étant plus négligeable sur un substrat non chauffé. On veut dire par là, que la température du substrat sur lequel la déposition est faite va en augmentant et en conséquence également la mobilité des espèces qui se condensent sur le substrat.

Pour minimiser ou annuler les phénomènes, ci-dessus évoqués, la grande majorité des procédés mettent en oeuvre des moyens permettant la densification des revêtements. Pour ce faire, l'homme de l'art dispose de techniques permettant un apport d'énergie sur les revêtements en cours de croissance : le chauffage des substrats et le bombardement ionique des couches en cours de croissance.

Comme il a été vu plus haut, ces techniques avec apport d'énergie au substrat, sont très largement répandues dans les procédés d'évaporation de couches minces.

Les inventeurs ont mis en évidence que ces techniques dégradaient les performances des couches minces en terme de seuil d'endommagement laser à 1,06 µm.

Cette idée est basée sur des études sur l'endommagement des couches minces par les lasers. Des résultats de ces études ont été publiés par J. Dijon et al., Nano absorbing center : a key point in laser damage of thin films, Proc. of 28th annual Boulder Damage Symposium, SPIE Vol. 2966 (1996) (C10). On notera que l'un des auteurs de cette publication est aussi l'un des inventeurs. Les résultats de ces études sont que la présence d'impuretés métalliques sous formes d'agrégats dans les revêtements provoque, via la création d'un mécanisme relais de chauffage des agrégats et de rayonnement dans l'ultraviolet profond, une transformation locale des couches les rendant absorbantes des rayonnements lasers à 1,06 µm, puis le couplage du laser sur le matériau et la destruction du revêtement.

Il est difficile d'éviter la présence d'impuretés métalliques au sein des traitements de surface qu'il s'agisse d'impuretés d'origine externe (matériau du creuset d'évaporation, impuretés de la charge d'évaporation, éléments constitutifs de la chambre d'évaporation en cas d'utilisation d'une source d'ions) ou d'atomes d'hafnium incomplètement oxydés.

Lorsque l'on chauffe, ou ce qui revient au même du point de vue apport énergétique au substrat, lorsque l'on bombarde par des ions la couche en cours de croissance, on favorise la cristallisation du dépôt.

On sait que les joints de grains présents dans un matériau cristallisé constituent des chemins privilégiés de diffusion des impuretés. Une structure amorphe peut " geler " la diffusion de ces impuretés.

Selon des observations faites par les inventeurs le phénomène de cristallisation de l'hafnie est nécessairement induit par l'énergie que l'on apporte au substrat par chauffage ou par bombardement ionique. Cette cristallisation se révèle par des pics de diffraction de rayons X. La cristallisation caractéristique de l'apport énergétique, se révèle aussi par microscopie électronique en transmission. Avec cette méthode les plans cristallins diffractent les électrons dans des directions précises donnant des anneaux bien définis à partir desquels il est possible de déterminer la structure cristalline du matériau, par exemple une structure monoclinique pour un dépôt effectué sur un substrat chauffé à 200° C.

### Brève description de l'invention

Compte tenu de l'état de la technique qui vient d'être décrit, les inventeurs ont pensé que tout apport énergétique est défavorable à la tenue au flux laser car il va favoriser la stabilisation de ces impuretés par la formation d'agrégats.

L'idée de base de l'invention, qui va à l'encontre des concepts habituels de l'homme de l'art, consiste à travailler sur un procédé non énergétique c'est-à-dire sans assistance ionique ni chauffage des substrats.

Les matériaux déposés sont alors amorphes, c'est-à-dire non cristallins. De plus, lorsqu'on travaille avec apport d'énergie, on crée une compaction de la couche déposée. Au contraire, le matériau déposé sans apport d'énergie présente une densité moindre. Il n'a pas été trouvé dans la documentation des inventeurs des données relatives à la densité de couches d'hafnie déposées par les procédés connus. Les densités les plus faibles connues des inventeurs sont de 8,5 g/cm³. Les densitées mesurées sur les couches d'hafnie selon l'invention s'échelonnent entre 6,4 et 8,1 g/cm³. Ces densités peuvent être mesurées par réflectrométrie de rayons X. Comme signalé plus haut, la cristallisation n'intervient que si l'on chauffe les substrats, ou ce qui du point de vue apport énergétique à la couche en cours de dépôt revient au même, si l'on bombarde par des ions la couche en cours de croissance. L'absence de cristallisation, selon les inventeurs, peut également expliquer la réduction de la formation d'agrégats car comme déjà signalé plus haut, les joints de grains présents dans un matériau cristallisé constituent des chemins privilégiés de diffusion des impuretés. Une structure amorphe peut "geler" la diffusion de ces impuretés.

En résumé, l'invention est relative à une couche mince d'oxyde d'hafnium caractérisé en ce que l'oxyde d'hafnium est sous forme amorphe avec une densité inférieure à 8 g/cm³.

Contrairement aux couches d'oxydes d'hafnium de l'art antérieur, une couche d'oxyde d'hafnium amorphe ne présente pas de pic de diffraction X. L'observation par microscopie électronique en transmission montre des anneaux diffus caractéristiques d'une structure amorphe.

L'invention est relative également à un empilement de couches minces caractérisé en ce qu'il comporte au moins une couche d'oxyde d'hafnium amorphe de densité inférieure à 8 g/cm³ ou encore à un composant optique ayant un traitement de surface caractérisé en ce que ledit traitement de surface comporte au moins une couche d'oxyde d'hafnium amorphe de densité inférieure à 8 g/cm³.

En général, ladite couche d'oxyde d'hafnium amorphe de densité inférieure à 8 g/cm³ fait partie d'un empilement de couches comportant au moins une couche ayant un indice de réfraction différent de celui de l'oxyde d'hafnium.

Enfin, l'invention est relative à un procédé de dépôt sous vide sur un substrat d'au moins une couche d'oxyde d'hafnium par évaporation réactive sous oxygène d'hafnium métallique, procédé caractérisé en ce que le dépôt est effectué sans apport d'énergie au substrat, que cet apport soit préalable au dépôt ou en cours de dépôt.

Lorsque l'on dit qu'il n'y a pas apport d'énergie, on veut dire que d'une part le substrat n'est pas chauffé ou préchauffé et que d'autre part, on n'utilise pas de procédé énergétique tel le bombardement ionique de la couche en cours de croissance, ou l'accélération des ions avant dépôt (ion plating). Le dépôt est un dépôt "naturel" par simple effet de condensation du matériau à déposer sur le substrat. Ce dépôt est alors amorphe, c'est-à-dire qu'il y a absence de cristallinité.

Comme indiqué plus haut, l'avantage principal apporté par des couches d'hafnie amorphe selon l'invention est la tenue très élevée au flux laser.

La monocouche d'hafnie selon l'invention, déposée sur silice, a pu supporter un flux laser supérieur à 15 joules/cm² à une longueur d'onde de 1,06 µm avec des impulsions de 3 ns ayant une fréquence de récurence de 10 Hz jusqu'à obtenir 15 joules/cm². Le meilleur art connu des inventeurs se situe dans les mêmes conditions dans une fourchette de 3 à 5 joules/cm².

De plus, le procédé à froid selon l'invention permet un gain très important sur le temps de cycle de l'enceinte de dépôt.

En effet, le chauffage des substrats peut immobiliser l'équipement de dépôt une journée complète par traitement pour les pièces les plus volumineuses, par exemple des miroirs de transport de faisceau du laser Mégajoule. Ce miroir sera décrit plus loin.

Avec le procédé à froid selon l'invention, la réalisation de ce type de miroir requiert un temps de cycle de 5 heures (mise sous vide de l'enceinte non comprise). Il est donc possible de réaliser un cycle de dépôt par jour, même s'il s'avérait qu'un refroidissement des composants entre chaque dépôt d'hafnie améliore sensiblement les performances des composants.

Enfin, avec le procédé selon l'invention, il n'est pas nécessaire de réaliser les dépôts sur des substrats possédant une grande stabilité thermique.

Dans les réalisations effectuées jusqu'à présent, il n'a pas été nécessaire de refroidir activement le substrat, ni de contrôler sa température de façon précise.

Pour des dépôts de quelques monocouches, le temps nécessaire est suffisamment court pour ne pas provoquer d'échauffement conséquent ; pour des dépôts plus épais, il a été procédé en deux étapes (ou plus si nécessaire) entrecoupées par des temps de refroidissement libre (exemple pendant une nuit). Il est possible aussi de prévoir des temps de refroidissement après le dépôt de chaque couche de HfO₂. Ces refroidissements ont typiquement une durée équivalente à une ou quelques durées du dépôt de la couche précédente.

Il est aussi possible, pour diminuer le temps d'utilisation de l'enceinte pour une réalisation monocouche ou multicouche particulière, de refroidir activement le substrat au cours de la croissance du dépôt ou pendant une période d'interruption du dépôt.

### Brève description des dessins.

Des exemples de réalisation d'empilements de couches minces parmi lesquelles des couches d'hafnie amorphe conforme à l'invention seront maintenant décrit en liaison avec les dessins annexés dans lesquels :
- La figure 1 représente une section d'un substrat portant une couche d'oxyde d'hafnium amorphe selon l'invention.
- Les figures 2 et 3 représentent des comparaisons entre les diagrammes de diffraction de rayons X :

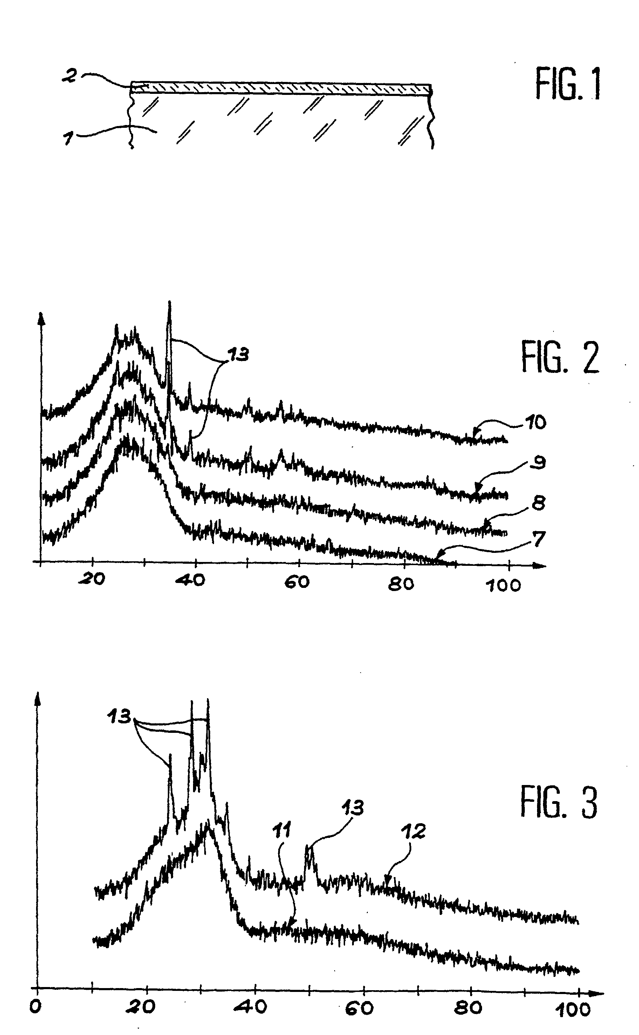

   - figure 2 entre des couches d'oxyde d'hafnium comportant des cristaux d'oxyde résultant du chauffage du substrat et une couche amorphe selon l'invention,

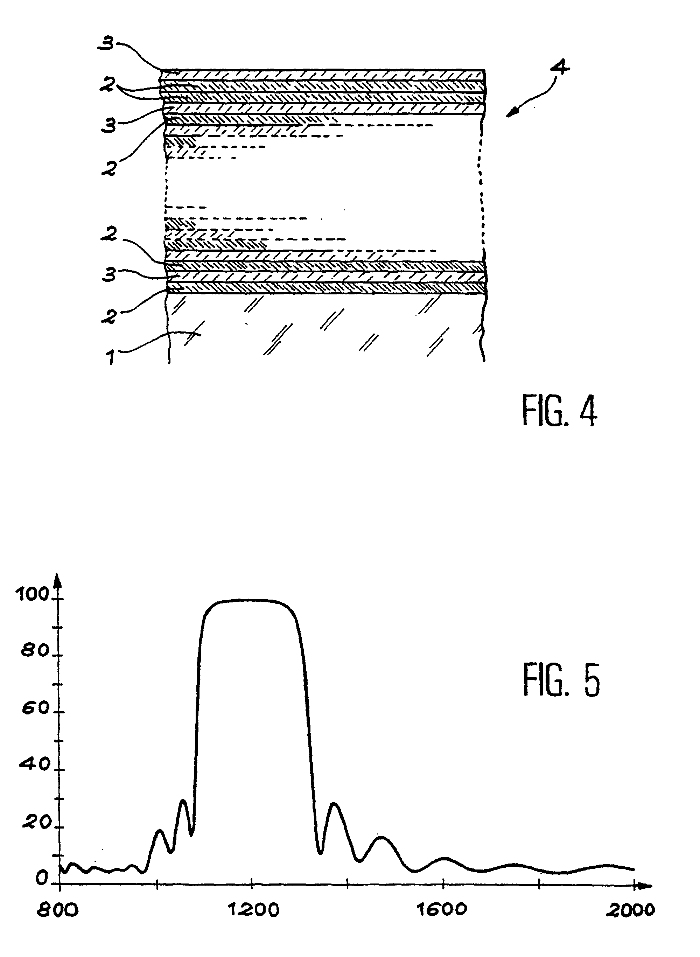

   - figure 3 entre une couche d'oxyde d'hafnium comportant des cristaux d'oxyde d'hafnium résultant du bombardement ionique du substrat et une couche amorphe selon l'invention.
- La figure 4 représente une section d'un substrat portant un empilement composé de couches d'oxyde d'hafnium amorphe selon l'invention et de couches d'oxyde de silicium, l'empilement assurant une fonction de miroir.
- La figure 5 est une courbe représentant la réflexion du composant miroir de la figure 4 en fonction de la longueur d'onde.

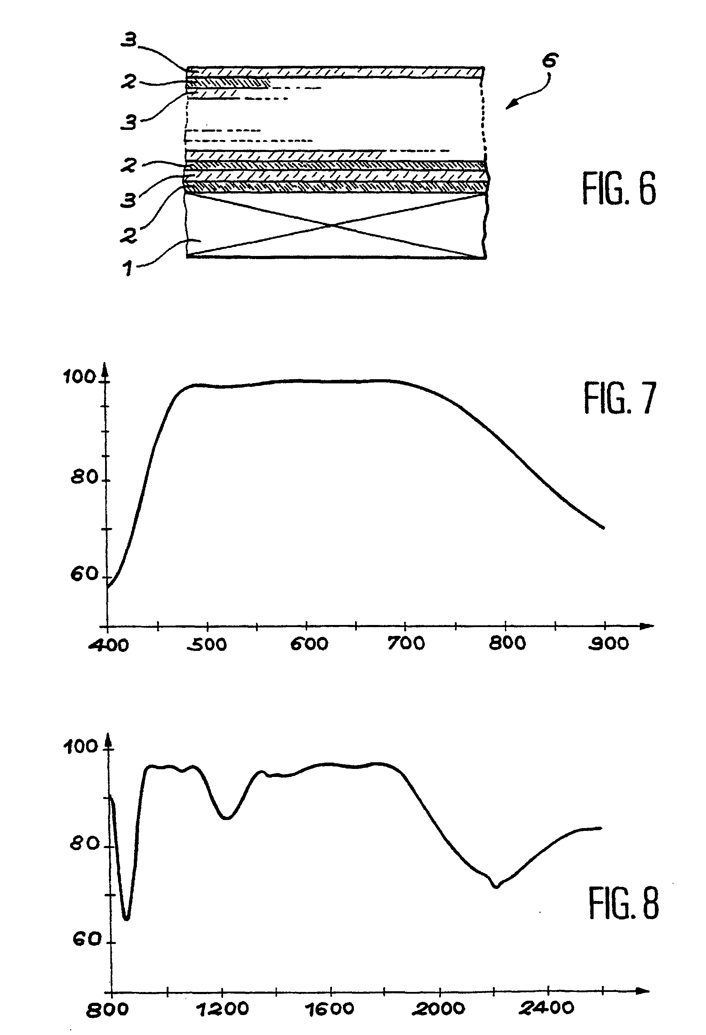

- La figure 6 est une section partielle d'un composant optique comportant un empilement alterné de couches d'hafnie amorphe et d'oxyde de silicium.
- La figure 7 est une courbe représentant les performances optiques d'un composant antireflet en terme de pourcentage de transmission de la lumière dans la gamme spectrale de travail.
- La figure 8 est une courbe représentant les valeurs de transmission d'un substrat de silice dans la gamme 800-2600 nm traité avec un empilement de 10 couches de HfO₂ et SiO₂ d'épaisseur totale 2300 nm.

### Description d'exemples de réalisation d'empilements de couches comportant des couches selon l'invention

La figure 1 représente une couche d'oxyde d'hafnium amorphe 2, conforme à l'invention déposée sur un substrat 1. On peut reconnaître que l'oxyde d'hafnium est amorphe par exemple par l'observation du diagramme de diffraction de rayons X.

De tels diagrammes sont représentés sur les figures 2 et 3.

La figure 2 représente des courbes 7, 8, 9, 10. Ces courbes représentent en unité arbitraire, l'intensité des rayons X diffractés en fonction de la valeur de l'angle de diffraction.

La courbe 7 représente le spectre de diffraction d'une couche d'hafnie élaborée à froid (sans chauffage du substrat de dépôt).

Les courbes 8, 9 et 10 représentent les spectres de diffraction de couche d'hafnie élaborées avec une température de substrat de dépôt de 100, 150° et 200°C respectivement.

La figure 3 présente deux courbes 11 et 12. Ces courbes représentent les spectres de diffraction de couches d'hafnie élaborées soit sans bombardement ionique de la couche en cours de croissance (courbe 11), soit avec bombardement ionique (courbe 12).

Les courbes 7 et 11 ne présentent pas de pics de diffraction 13 : les couches d'hafnie sont donc amorphes.

En revanche, les couches 8, 9, 10 et 12 présentent des pics de diffraction 13 caractéristiques des matériaux cristallins.

Les exemples de réalisation qui vont suivre sont pour les raisons exposées plus haut réalisés par des empilements de couches HfO₂/SiO₂.

Les couches d'hafnie amorphe sont déposées à froid conformément au procédé de l'invention, de même les couches d'oxyde de silicium sont déposées sans chauffage intentionnel ni bombardement ionique des substrats.

Un premier exemple de réalisation concerne la réalisation d'un miroir 4 à 1064 nm. Le composant 4 doit assurer une fonction réflectrice à 1064 nm sous une incidence de 45°. Ce miroir 4 est réalisé par un empilement de formule 12 (HB) H2B où H symbolise une monocouche d'épaisseur 156 nm de HfO₂ et B une monocouche de 213 nm de SiO₂.

Une section transversale de ce composant optique 4 destiné à montrer l'empilement des couches est représentée figure 4. Sur un substrat 1, le miroir conforme à l'invention comporte tout d'abord un empilement de douze couches H d'oxyde d'hafnium amorphe 2, alternées chacune avec une couche B d'oxyde de silicium 3. Il comporte ensuite deux couches H d'oxyde d'hafnium amorphe 2 et enfin une couche B d'oxyde de silicium 3.

Pour la réalisation de tels empilements épais, le rayonnement de l'hafnium porté à plus de 2000° C crée une élévation progressive de la température par rayonnement direct sur les substrats. Si l'on ne prend pas de précautions particulières, on estime à partir de mesures par thermocouple que la température approche 100°C en fin d'évaporation. Il est possible de réduire cette élévation de température en intercalant dans le procédé des temps de refroidissement. Dans cet exemple de réalisation la couche réflectrice a été obtenue en deux étapes avec une phase de refroidissement naturel en milieu d'empilement. La figure 5 présente la réflexion du composant en fonction de la longueur d'onde. La réflexion atteint 99,5% à 1200 nm. Une mesure sous une incidence de 45° donne une réflectivité à 1064 nm supérieure à 99%. Un test d'endommagement a été effectué à fluence croissante selon la méthode "R 0n 1" décrite page 523 du document C2. Selon cette méthode, chaque zone de test est illuminée avec des séries croissantes de plusieurs centaines d'impulsions, ici de 3 nanosecondes chacune avec une fréquence de récurrence de 10 hertz, de fluence croissante. Les seuils moyens d'endommagement mesurés sont de l'ordre de 50 joules/cm², c'est à dire une valeur beaucoup plus élevée que tout ce qui est annoncé dans les publications actuelles. Ainsi Waldorf et al rapportent dans le document C3 avoir obtenu des valeurs de seuils d'endommagement laser à 1,06µm inférieures à 2 joules/cm² à partir d'évaporation d'hafnium, mais avec accélération ionique, (énergie des espèces Ar⁺ et O₂⁺ qui bombardent le substrat en cours de croissance de l'ordre de 40 eV dans cette étude) donc apport énergétique au substrat qui se traduit par une cristallisation de l'oxyde d'hafnium contrairement au procédé de l'invention qui lui est sans apport énergétique et aboutit à des couches d'oxyde d'hafnium amorphe.

Les inventeurs pensent que ces bons résultats sont dus à l'absence d'agrégats métalliques et/ou à la forme amorphe des couches d'hafnie selon l'invention alors qu'au contraire, selon l'état antérieur de la technique l'apport énergétique aboutit à la cristallisation du matériau.

Le second exemple est relatif à un traitement de surface antireflet dans la gamme de longueur d'onde 550 à 670 nm. Ce traitement peut par exemple être utilisé comme traitement d'un composant optique entrant dans une chaîne laser SILVA utilisée pour la séparation isotopique par laser d'uranium en phase vapeur. Un empilement de six couches de HfO₂/SiO₂ d'épaisseur totale de 630 nm a été déposé sur chacune des faces d'un substrat, les couches d'hafnie amorphe étant déposées avec le procédé selon l'invention.

Sur la figure 6, le composant optique 6 a été représenté, dans un but de simplification, avec une seule fois la composition bicouche comprenant une couche d'hafnie amorphe 2 alternée avec une couche d'oxyde de silicium 3.

La courbe de la figure 7 représente les performances optiques du composant 6 en terme de pourcentage de transmission de la lumière dans la gamme spectrale de travail exprimée en nm. On voit que le pourcentage est très voisin de 100% dans toute la gamme de travail. Le comportement sous flux laser de ce composant s'est révélé excellent dans la gamme de longueur d'onde d'utilisation.

Ainsi, le composant a résisté à un éclairement supérieur à 80 kW/cm² par un laser émettant à une longueur d'onde de 578 nanomètres. La fréquence des impulsions d'éclairement de 3 ns chacune était de 5,6 KHz et la durée d'exposition a été de cinq minutes environ.

Le troisième exemple est relatif à la réalisation d'un traitement antireflet 3 bandes. Le composant présenté dans cet exemple fait partie d'un dispositif d'oscillateur paramétrique optique (OPO). Ce traitement est déposé sur un cristal de phosphate de potassium et de titanyl (KTiPO₄) couramment appelé KTP qui est soumis à une irradiation laser à 1064 nm. Les caractéristiques du cristal sont telles que cette irradiation induit une émission de photons à 1572 et 3292 nm. L'objectif du traitement est d'éliminer les réflexions parasites à ces longueurs d'onde de façon à améliorer les performances de l'OPO. La figure 8 présente les valeurs de transmission d'un substrat de silice dans la gamme 800-2600 nm traité avec un empilement de 10 couches de HfO₂ et SiO₂ d'épaisseur totale 2300 nm. La représentation de ce traitement sur le cristal de KTP n'améliorerait pas la compréhension de l'invention, aussi il n'a pas été représenté. Des mesures de réflectivité résiduelle sur le cristal de KTP sont aux longueurs d'onde de travail de :
- R = 0,1% à 1064 nm
- R = 0,01% à 1572 nm
- R < 7% à 3292 nm

Le seuil d'endommagement laser à 1064 nm est de 23 J.cm⁻², ce qui est remarquable pour un traitement faiblement réflecteur à cette longueur d'onde ; en effet la quasi-totalité du flux traverse le composant et sollicite l'ensemble de l'empilement.

### Exemple de réalisation du procédé selon l'invention

Des indications relatives au procédé de réalisation de couches d'hafnie selon l'invention ont déjà été données plus haut.

Pour les trois exemples de réalisation décrits ci-dessus, les conditions de réalisation ont été conformes au tableau ci-après :

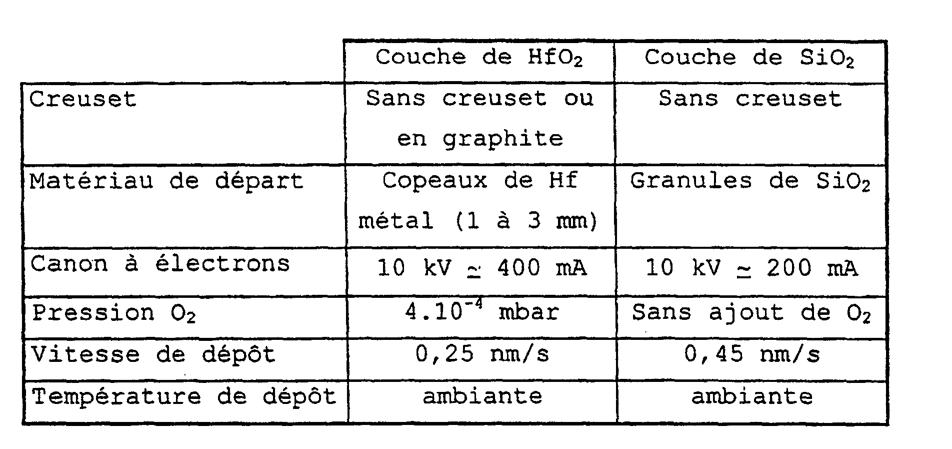

Une différence significative par rapport à l'art antérieur est comme on le voit la température du substrat de dépôt qui est égale à la température ambiante, soit 20°C environ et non pas 200°C comme dans l'art antérieur.

## Revendications

1. Couche mince d'oxyde d'hafnium, **caractérisée en ce que** l'oxyde d'hafnium est sous forme amorphe avec une densité inférieure à 8 g/cm³.

2. Empilement de couches minces, **caractérisé en ce qu'**il comporte au moins une couche d'oxyde d'hafnium amorphe ayant une densité inférieure à 8 g/cm³.

3. Empilement de couches minces selon la revendication 2, **caractérisé en ce que** l'empilement comporte au moins une couche d'un autre matériau disposé au-dessus ou en dessous de la couche d'oxyde d'hafnium amorphe ayant une densité inférieure à 8 g/cm³.

4. Empilement de couches minces selon la revendication 3, **caractérisé en ce que** l'autre matériau est de l'oxyde de silicium.

5. Empilement de couches minces selon la revendication 2, **caractérisé en ce que** l'empilement comporte des couches alternées d'oxyde d'hafnium amorphe ayant une densité inférieure à 8 g/cm³ et d'un autre matériau.

6. Empilement de couches minces selon la revendication 5, **caractérisé en ce que** l'autre matériau est de l'oxyde de silicium.

7. Composant optique ayant un traitement de surface, **caractérisé en ce que** ledit traitement de surface comporte au moins une couche d'oxyde d'hafnium amorphe ayant une densité inférieure à 8 g/cm³.

8. Composant optique selon la revendication 7, **caractérisé en ce que** ledit traitement comporte un empilement de couches minces.

9. Composant optique selon la revendication 8, **caractérisé en ce que** l'empilement comporte des couches alternées d'oxyde d'hafnium amorphe de densité inférieure à 8 g/cm³ et d'un autre matériau.

10. Composant optique selon la revendication 9, **caractérisé en ce que** l'autre matériau est de l'oxyde de silicium.

11. Procédé de dépôt sous vide sur un substrat d'au moins une couche d'oxyde d'hafnium amorphe par évaporation réactive sous oxygène, d'hafnium métallique, procédé **caractérisé en ce que** le dépôt est effectué sans apport d'énergie au substrat.

12. Procédé selon la revendication 11, **caractérisé en ce que** le dépôt est interrompu, puis repris, pour laisser le substrat se refroidir.

13. Procédé selon la revendication 11, **caractérisé en ce qu'**on refroidit le substrat en cours de dépôt ou pendant des périodes d'interruption du dépôt.

## Claims

1. Thin layer of hafnium oxide, **characterised in that** the hafnium oxide is under amorphous form with a density less than 8 gm/cm³.

2. Stack of thin layers, **characterised in that** it comprises at least one layer of amorphous hafnium oxide with a density less than 8 gm/cm³.

3. Stack of thin layers according to Claim 2, **characterised in that** the stack comprises at least one layer of another material deposited above or below the amorphous hafnium oxide layer with a density less than 8 gm/cm³.

4. Stack of thin layers according to Claim 3, **characterised in that** the other material is silicon oxide.

5. Stack of thin layers according to Claim 2, **characterised in that** the stack comprises alternate layers of amorphous hafnium oxide with a density less than 8 gm/cm³ and another material.

6. Stack of thin layers according to Claim 5, **characterised in that** the other material is silicon oxide.

7. Optical component with a surface treatment, **characterised in that** said surface treatment comprises at least one layer of amorphous hafnium oxide with a density less than 8 gm/cm³.

8. Optical component according to Claim 7, **characterised in that** said treatment comprises a stack of thin layers.

9. Optical component according to Claim 8, **characterised in that** the stack comprises alternate layers of amorphous hafnium oxide of density less than 8 gm/cm³ and another material.

10. Optical component according to Claim 9, **characterised in that** the other material is silicon oxide.

11. Process for vacuum deposit on a substrate of at least one layer of amorphous hafnium oxide by reactive evaporation under oxygen, of metallic hafnium, the process **characterised in that** the deposit is carried out without energy input to the substrate.

12. Process according to Claim 11, **characterised in that** the deposit is interrupted, and then restarted, to allow the substrate to cool.

13. Process according to Claim 11, **characterised in that** the substrate is cooled during deposit or during periods of interruption of deposit.

## Patentansprüche

1. Dünnfilm aus Hafniumoxid, **dadurch gekennzeichnet, dass** das Hafniumoxid in amorpher Form mit einer Dichte von < 8 g/cm³ vorliegt.

2. Stapel von Dünnfilmen, **dadurch gekennzeichnet, dass** er mindestens einen Film aus amorphem Hafniumoxid mit einer Dichte von < 8 g/cm³ aufweist.

3. Stapel von Dünnfilmen nach Anspruch 2, **dadurch gekennzeichnet, dass** er mindestens einen Film aus einem anderen Material aufweist, der oberhalb oder unterhalb des Films aus amorphem Hafniumoxid mit einer Dichte von < 8 g/cm³ angeordnet ist.

4. Stapel von Dünnfilmen nach Anspruch 3, **dadurch gekennzeichnet, dass** es sich bei dem anderen Material um Siliciumoxid handelt.

5. Stapel von Dünnfilmen nach Anspruch 2, **dadurch gekennzeichnet, dass** er altemierende Filme aus amorphem Hafniumoxid mit einer Dichte von < 8 g/cm³ und aus einem anderen Material aufweist.

6. Stapel von Dünnfitmen nach Anspruch 5, **dadurch gekennzeichnet, dass** es sich bei dem anderen Material um Siliciumoxid handelt.

7. Optisches Element, das eine Oberflächenvergütung aufweist, **dadurch gekennzeichnet, dass** es sich bei der Oberflächenvergütung um mindestens einen Film aus amorphem Hafniumoxid mit einer Dichte von < 8 g/cm³ handelt.

8. Optisches Element nach Anspruch 7, **dadurch gekennzeichnet, dass** die Vergütung einen Stapel von Dünnfilmen umfasst.

9. Optisches Element nach Anspruch 8, **dadurch gekennzeichnet, dass** der Stapel alternierende Filme aus amorphem Hafniumoxid mit einer Dichte von < 8 g/cm³ und aus einem anderen Material aufweist.

10. Optisches Element nach Anspruch 9, **dadurch gekennzeichnet, dass** es sich bei dem anderen Material um Siliciumoxid handelt.

11. Verfahren zur Abscheidung unter Vakuum mindestens eines Films aus amorphem Hafniumoxid auf einem Substrat durch reaktive Verdampfung von metallischem Hafnium unter Sauerstoff, **dadurch gekennzeichnet, dass** die Abscheidung ohne Zufuhr von Energie zu dem Substrat durchgeführt wird.

12. Verfahren nach Anspruch 11, **dadurch gekennzeichnet, dass** die Abscheidung unterbrochen und dann wieder aufgenommen wird, um das Substrat sich abkühlen zu lassen.

13. Verfahren nach Anspruch 11, **dadurch gekennzeichnet, dass** man das Substrat während der Abscheidung oder während der Abscheidungs-Unterbrechungsperioden abkühlt.
